# EUROPÄISCHE PATENTANMELDUNG

(11) **EP 1 182 666 A1**
(43) Veröffentlichungstag der Anmeldung: **27.02.2002**
(21) Anmeldenummer: 01115012.5
(22) Anmeldetag: 20.06.2001
(51) Int. Cl.: G11C 11/16, G11C 8/08

(54) **Integrierter Speicher mit Speicherzellen mit magnetoresistivem Speichereffekt**

(30) Priorität: 10.07.2000 DE 10033486
(71) Anmelder: Infineon Technologies AG, 81669 München (DE)
(72) Erfinder: Hartmann, Udo, 81541 München (DE)
(74) Vertreter: Epping Hermann & Fischer

(57) **Zusammenfassung**

Ein integrierter Speicher weist Speicherzellen (MC1 bis MC3) mit magnetoresistivem Speichereffekt auf, die jeweils mit einer gemeinsamen elektrischen Leitung (WLk) verbunden sind. Die Leitung (WLk) weist eine erste Leiterbahn (LB1) und eine zweite Leiterbahn (LB2) auf, sowie einen ersten Anschluß (A1) und zweiten Anschluß (A2), zwischen denen die Leitung (WLk) mit den Speicherzellen (MC1 bis MC3) verbunden ist. Die erste Leiterbahn (LB1) ist an dem ersten Anschluß (A1) mit einer Stromquelle (Q1) und die zweite Leiterbahn (LB2) ist an dem zweiten Anschluß (A2) mit einer weiteren Stromquelle (Q2) verbunden zum Einschreiben von Daten in eine der Speicherzellen (MC1 bis MC3). Dadurch ist eine relativ hohe Zuverlässigkeit des Speichers hinsichtlich der zu speichernden Daten ermöglicht.

## Beschreibung

Integrierter Speicher mit Speicherzellen mit magnetoresistivem Speichereffekt

Die vorliegende Erfindung betrifft einen integrierten Speicher mit Speicherzellen mit magnetoresistivem Speichereffekt.

Speicherzellen mit magnetoresistivem Speichereffekt weisen zur Speicherung von Datensignalen im allgemeinen in ihrem Zustand veränderbare ferromagnetische Schichten auf. Dieser Speichereffekt ist allgemein als sogenannter GMR-Effekt (Giant Magnetoresitive) oder TMR-Effekt (Tunnelling Magnetoresistive) bekannt. Dabei ist der elektrische Widerstand einer derartigen Speicherzelle abhängig von der Magnetisierung in den ferromagnetischen Schichten.

Integrierte Speicher mit derartigen Speicherzellen, auch als sogenannte MRAM-Speicher bezeichnet, sind oftmals ähnlich aufgebaut wie beispielsweise integrierte Speicher vom Typ DRAM. Derartige Speicher weisen im allgemeinen eine Speicherzellenanordnung mit untereinander im wesentlichen parallel verlaufenden Zeilenleitungen und Spaltenleitungen auf, wobei die Zeilenleitungen üblicherweise quer zu den Spaltenleitungen verlaufen.

Ein derartiger MRAM-Speicher ist aus WO99/14760 bekannt. Dort sind die Speicherzellen jeweils entlang von Zeilenleitungen zwischen die jeweilige Zeilenleitung und jeweiligen Spaltenleitungen geschaltet und mit der jeweiligen Spaltenleitung und Zeilenleitung elektrisch verbunden. Die Speicherzellen mit magnetoresistivem Speichereffekt sind dabei hochohmiger als die Zeilenleitungen und Spaltenleitungen. Die Spaltenleitungen sind zum Auslesen eines Datensignals einer der Speicherzellen mit einem Leseverstärker verbunden. Zum Auslesen wird der auf der Spaltenleitung detektierbare Strom gemessen.

Bei einem derartigen MRAM-Speicher sind keine Dioden oder Transistoren wie bei einem DRAM-Speicher vorhanden, die zum Auslesen eines Datensignals die Speicherzellen abhängig von der Adressierung mit der jeweiligen Spaltenleitung verbinden. Dadurch erhält man insbesondere Vorteile bei der geometrischen Anordnung der Speicherzellen. Insbesondere kann durch eine gestapelte Anordnung der Speicherzellen eine Platzersparnis bei der Anordnung der Speicherzellen erzielt werden. Allerdings tritt dadurch ein gewisser Leckstrom durch diejenigen Speicherzellen auf, die an einer ausgewählten Zeilenleitung oder Spaltenleitung angeschlossen sind, jedoch nicht auszulesen oder zu beschreiben sind.

Zum Schreiben von Information in eine der Speicherzellen ist im allgemeinen ein Magnetfeld für die betreffende Speicherzelle zu erzeugen, das eine magnetische Schicht der Speicherzelle in einen entsprechenden Zustand versetzt. Dieses Magnetfeld wird durch jeweilige Ströme (beziehungsweise durch Überlagerung von deren Magnetfeldern) erzeugt, die in die angeschlossene Zeilenleitung und Spaltenleitung an einer jeweiligen Einspeisestelle eingespeist werden. Infolge der Leckströme durch die an der betroffenen Zeilenleitung und Spaltenleitung angeschlossenen Speicherzellen, die sich mit der Anzahl der Speicherzellen aufsummieren, ist dieser Strom an der Einspeisestelle in einem gewissen Toleranzbereich so einzustellen, daß sichergestellt ist, daß auch für alle Speicherzellen entlang der gemeinsamen Zeilenleitung oder Spaltenleitung der erforderliche Strom zum Beschreiben einer der Speicherzellen eingespeist wird. Dies hat insbesondere zur Folge, daß eine treibende Stromquelle oder ein Stromtreiber entsprechend groß dimensioniert werden muß. Außerdem werden die Speicherzellen abhängig von ihrer relativen Lage zur Einspeisestelle mit einem unterschiedlich starken Strom beziehungsweise Magnetfeld beschrieben. Insgesamt kann die Zuverlässigkeit des Speichers hinsichtlich der zu speichernden Daten beeinträchtigt werden, wenn zum Beispiel durch Alterung der Leckstrom einer oder mehrerer Speicherzellen zunimmt und ein solcher Toleranzbereich relativ knapp bemessen ist.

Die Aufgabe der vorliegenden Erfindung ist es, einen integrierten Speicher mit Speicherzellen mit magnetoresistivem Speichereffekt anzugeben, bei dem eine relativ hohe Zuverlässigkeit hinsichtlich der zu speichernden Daten ermöglicht ist.

Die Aufgabe wird gelöst durch einen integrierten Speicher mit Speicherzellen mit magnetoresistivem Speichereffekt, die jeweils mit einer gemeinsamen elektrischen Leitung verbunden sind, bei dem die Leitung eine erste Leiterbahn und eine zweite Leiterbahn aufweist, bei dem die Leitung einen ersten Anschluß und zweiten Anschluß aufweist und zwischen den Anschlüssen an Kopplungsknoten mit den Speicherzellen verbunden ist, und bei dem der erste Anschluß der ersten Leiterbahn mit einer Stromquelle und der zweite Anschluß der zweiten Leiterbahn mit einer weiteren Stromquelle verbunden sind zum Einschreiben von Information in eine der Speicherzellen.

Durch den Einsatz von zwei Stromquellen, welche relativ zu den Speicherzellen an entgegengesetzten Enden mit der gemeinsamen Leitung verbunden sind, ergibt sich zum Einschreiben von Information in eine der Speicherzellen aus Sicht der Speicherzellen ein wesentlich gleichmäßigerer Verlauf des zu bewirkenden Magnetfelds, das zum Einschreiben von Information erforderlich ist. Die von der Stromquelle und der weiteren Stromquelle eingespeisten Ströme ergeben ein nach dem Superpositionsprinzip resultierendes Magnetfeld für die betreffende Speicherzelle.

Dadurch ist vorteilhaft vermieden, daß ein an einer einzelnen Stelle einzuspeisender Strom in einem relativ großen Toleranzbereich eingestellt werden muß, um die Leckströme der an der Leitung angeschlossenen Speicherzellen, die für einen Schreibvorgang nicht ausgewählt sind, zu kompensieren. Ist ein solcher Toleranzbereich beispielsweise relativ knapp bemessen, so kann die Zuverlässigkeit des integrierten Speichers hinsichtlich der zu speichernden Daten beeinträchtigt sein, wenn beispielsweise durch Alterung der Leckstrom einer oder mehrerer Speicherzellen zunimmt. Da bei der Erfindung der resultierende wirksame Strom zur Erzeugung des Magnetfeldes einen gleichmäßigeren Verlauf aufweist, wird dies weitgehend vermieden, wodurch der integrierte Speicher eine erhöhte Zuverlässigkeit hinsichtlich der zu speichernden Daten aufweist.

In einer Weiterbildung der Erfindung sind die Speicherzellen in einem Speicherzellenfeld angeordnet, das Spaltenleitungen und Zeilenleitungen aufweist. Die Speicherzellen sind dabei jeweils mit einer der Spaltenleitungen und einer der Zeilenleitungen verbunden. Die gemeinsame Leitung ist dabei als eine der Zeilenleitungen oder Spaltenleitungen ausgeführt. Dabei ist es vorteilhaft, daß alle Zeilenleitungen und Spaltenleitungen des integrierten Speichers jeweils zwei Leiterbahnen aufweisen, die zum Einschreiben von Information jeweils mit einer Stromquelle verbunden sind. Es ist jedoch auch möglich, daß entweder die Zeilenleitungen oder die Spaltenleitungen in erfindungsgemäßer Weise ausgebildet sind.

Die Stromquelle und die weitere Stromquelle können jeweils kleiner dimensioniert werden als eine einzelne Stromquelle, die einen Strom nur an einer einzelnen Einspeisestelle der betreffenden Leitung einspeist. Die zwei vorzusehenden Stromquellen können an geeigneter Stelle, beispielsweise am Rand des Speicherzellenfeldes, angeordnet werden. Entsprechend dem Verlauf der Zeilenleitungen beziehungsweise Spaltenleitungen befinden sich die Stromquelle und die weitere Stromquelle dabei an gegenüberliegenden Seiten des Speicherzellenfeldes.

Um einen weitgehend gleichmäßigen Verlauf des wirksamen Stroms zu erhalten, ist es vorteilhaft, daß die Stromquelle und die weitere Stromquelle jeweils einen Strom mit einem im wesentlichen gleichen Betrag einspeisen. Es ist daher vorteilhaft, daß die Stromquelle und die weitere Stromquelle einen weitgehend gleichen Schaltungsaufbau aufweisen.

Weitere vorteilhafte Aus- und Weiterbildungen sind in Unteransprüchen gekennzeichnet.

Die Erfindung wird im folgenden anhand der in der Zeichnung dargestellten Figuren näher erläutert. Es zeigen:
- Figur 1: ein Ausführungsbeispiel eines integrierten MRAM-Speichers,
- Figur 2: ein Ausführungsbeispiel eines erfindungsgemäßen integrierten Speichers,
- Figur 3: einen Stromverlauf des Speichers nach Figur 2,
- Figur 4: ein Ausführungsbeispiel eines Speichers, der mit einer einzelnen Stromquelle verbunden ist,
- Figur 5: einen Stromverlauf des Speichers nach Figur 4.

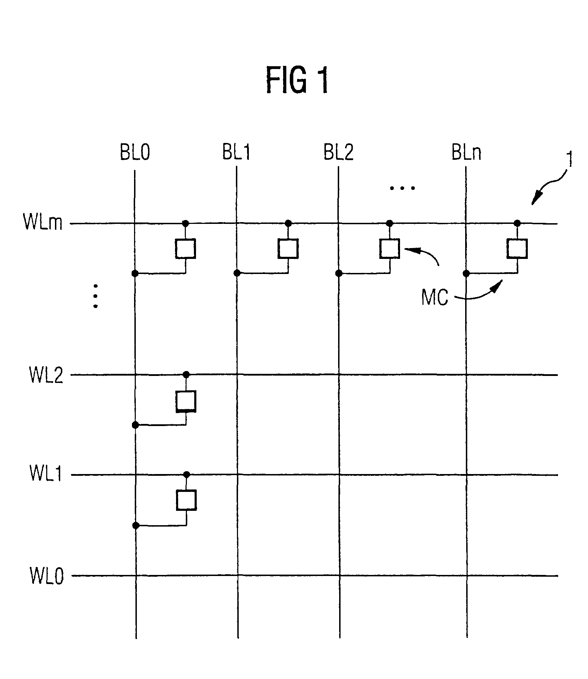

Figur 1 zeigt ein Ausführungsbeispiel eines MRAM-Speichers mit Speicherzellen MC mit magnetoresistivem Speichereffekt. Als Speicherzellen sind alle bekannten GMR-/TMR-Elemente geeignet, sofern sie hochohmiger sind als die Spaltenleitungen, hier als Bitleitungen BL0 bis BLn bezeichnet, und die Zeilenleitungen, hier als Wortleitungen WL0 bis WLm bezeichnet. Der Speicher weist hier eine beispielhafte Anzahl von Wortleitungen und Bitleitungen auf. Die Speicherzellen MC, die in einem matrixförmigen Speicherzellenfeld 1 angeordnet sind, sind jeweils zwischen eine der Bitleitungen BL0 bis BLn und eine der Wortleitungen WL0 bis WLm geschaltet.

Zum Einschreiben einer Information beziehungsweise eines Datensignals in eine der Speicherzellen MC wird die entsprechende angeschlossene Bitleitung und Wortleitung mit einer jeweiligen Stromquelle verbunden, die in Figur 1 nicht dargestellt sind. Durch die in den entsprechenden Leitungen fließenden Ströme wird an dem Kreuzungspunkt der Leitungen, an dem die betreffende Speicherzelle MC angeordnet ist, ein überlagertes Magnetfeld erzeugt, das eine magnetische Schicht der betreffenden Speicherzelle in einem bestimmten Zustand versetzt.

Zum Auslesen eines Datensignals aus einer der Speicherzellen MC ist die entsprechende Bitleitung beispielsweise mit einem Leseverstärker verbunden, der in Figur 1 ebenfalls nicht dargestellt ist. Zum Auslesen wird die betreffende Wortleitung angesteuert und mit einem vorgegebenen Potential beaufschlagt, so daß ein Stromfluß durch die auszulesende Speicherzelle auftritt. Alle anderen Wortleitungen werden auf beispielsweise Bezugspotential gelegt. Der Stromfluß durch die Speicherzelle wird durch den Leseverstärker an der angeschlossenen Bitleitung detektiert.

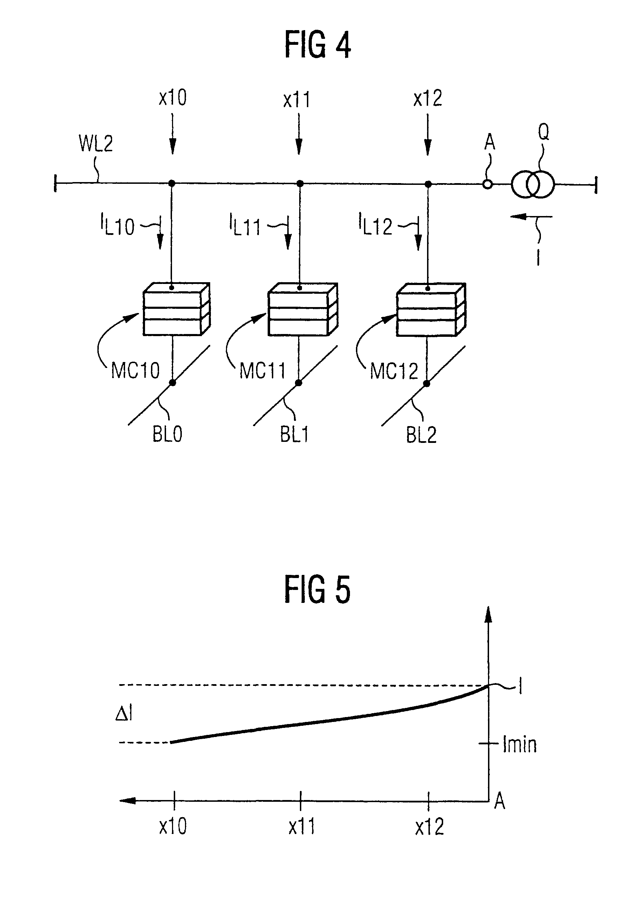

Figur 4 zeigt in einer Ausführungsform des Speichers nach Figur 1 eine Wortleitung WL2, an der die Speicherzellen MC10, MC11 und MC12 angeschlossen sind. Diese sind jeweils mit den Bitleitungen BL0, BL1 beziehungsweise BL2 verbunden. Zum Einschreiben eines Datensignals beispielsweise in die Speicherzelle MC10 wird die Wortleitung WL2 mit der Stromquelle Q verbunden. Entsprechendes wird für die Spaltenleitung BL0 durchgeführt. Die Stromquelle Q treibt einen Strom I in der Leitung WL2. Da die Speicherzellen MC10 bis MC12 nicht über Schaltmittel, wie beispielsweise Transistoren mit der Wortleitung WL2 verbunden sind, tritt in den Speicherzellen ein Leckstrom IL10, IL11 beziehungsweise IL12 auf. Um die Speicherzelle MC10 ordnungsgemäß mit dem Datensignal zu beschreiben, ist an der Speicherzelle MC10 ein minimaler Strom Imin erforderlich zur Erzeugung eines entsprechenden Magnetfeldes. Um diesen Strom zu erreichen, ist es erforderlich, daß an der Einspeisestelle A ein erhöhter Strom I eingespeist wird, um die Leckströme IL11 und IL12 zu kompensieren.

Ein beispielhafter schematischer Stromverlauf für den Strom I nach Figur 4 ist in Figur 5 gezeigt. Infolge der Leckströme IL11 und IL12 ist der Strom I an dem Ort x10, an dem die Speicherzelle MC10 mit der Wortleitung WL2 verbunden ist, um den Betrag △I vermindert. Das bedeutet, daß entsprechend der Anzahl der an der Wortleitung WL2 angeschlossenen Speicherzellen ein um die Summe der Leckströme erhöhter Strom I eingespeist werden muß, um an der Speicherzelle MC10 den Strom Imin zu erzeugen. Die Stromquelle Q muß daher entsprechend groß dimensioniert werden.

Die Speicherzellen MC10 bis MC12 werden von der Stromquelle Q entsprechend der örtlich unterschiedlichen Ströme beziehungsweise Magnetfelder unterschiedlich stark beschrieben. Für den Fall, daß beispielsweise infolge von Alterung ein Leckstrom einer der Speicherzellen zunimmt, kann die Zuverlässigkeit des Speichers hinsichtlich der zu speichernden Daten beeinträchtigt werden, insbesondere wenn der minimal erforderliche Strom Imin an einer zu schreibenden Speicherzelle unterschritten wird.

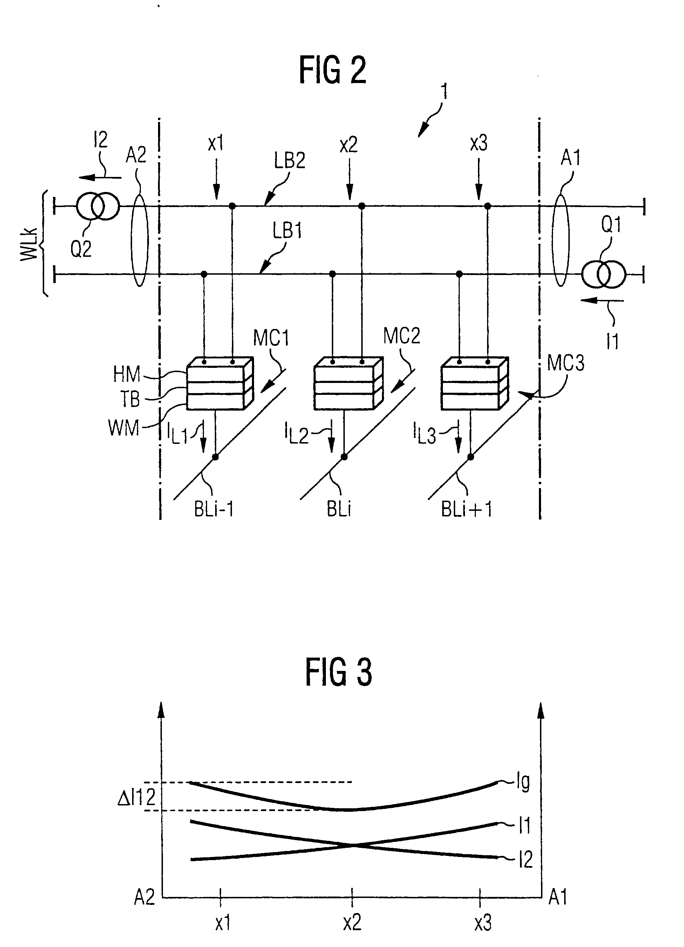

Figur 2 zeigt einen Ausschnitt eines vereinfacht dargestellten erfindungsgemäßen integrierten Speichers mit einer Wortleitung WLk und den Bitleitungen BLi-1, BLi und BLi+1, die in einem Speicherzellenfeld 1 nach der Struktur gemäß Figur 1 angeordnet sind. Die magnetoresistiven Speicherzellen MC1 bis MC3 sind jeweils mit der gemeinsamen Wortleitung WLk verbunden. Die Speicherzellen MC1 bis MC3 sind dabei an den Kopplungsknoten x1 bis x3 mit der Wortleitung WLk verbunden. Die Wortleitung WLk weist eine erste Leiterbahn LB1 und eine zweite Leiterbahn LB2 auf. Die Wortleitung WLk weist die Anschlüsse A1 und A2 auf, zwischen den Anschlüssen A1 und A2 ist die Wortleitung WLk an den Kopplungsknoten x1 bis x3 mit den Speicherzellen MC1 bis MC3 verbunden. Die Leiterbahn LB1 ist an dem Anschluß A1 mit einer Stromquelle Q1 verbunden. Die zweite Leiterbahn LB2 ist an dem Anschluß A2 mit einer weiteren Stromquelle Q2 verbunden. Die Stromquelle Q1 treibt dabei den Strom I1, die Stromquelle Q2 den Strom I2. Beim Schreiben eines Datensignals in eine der Speicherzellen MC1 bis MC3 sind die Leiterbahnen LB1, LB2 jeweils mit den Stromquellen Q1 beziehungsweise Q2 verbunden. Es tritt dabei in den Speicherzellen jeweils ein Leckstrom IL1 bis IL3 auf.

In dem gezeigten Ausführungsbeispiel befinden sich der Anschluß A1 und der Anschluß A2 an gegenüberliegenden Seiten des Speicherzellenfeldes 1. Ebenso sind die Stromquelle Q1 und die weitere Stromquelle Q2 an gegenüberliegenden Seiten des Speicherzellenfeldes 1 angeordnet. Die Beträge der Ströme I1 und I2 sind im wesentlichen gleich. Dies wird durch einen weitgehend gleichen Schaltungsaufbau der Stromquellen Q1 und Q2 erreicht.

Die in Figur 2 bezüglich der Wortleitung WLk dargestellte Schaltungsanordnung ist analog ebenfalls auf eine der Bitleitungen BLi-1 bis BLi+1 anwendbar, da diese zum Schreiben eines Datensignals in eine der angeschlossenen Speicherzellen ebenfalls jeweils mit einer entsprechenden Stromquelle verbunden sind. Dabei bilden die durch die entsprechende Wortleitung beziehungsweise Bitleitung erzeugten Magnetfelder ein überlagertes resultierendes Magnetfeld zum Programmieren der entsprechenden Speicherzelle.

In Figur 3 ist schematisch ein beispielhafter Stromverlauf des Speichers nach Figur 2 gezeigt. Die Ströme I1 und I2 werden an den Anschlüssen A1 beziehungsweise A2 eingespeist. Die Ströme I1 und I2 erzeugen nach dem Superpositionsprinzip ein resultierendes Magnetfeld, das durch den wirksamen Strom Ig = I1 + I2 repräsentiert wird. Infolge der Leckströme IL1 und IL3 weist der wirksame Strom Ig an dem Kopplungsknoten x2 eine Abweichung ΔI12 von dem Betrag Ig an den Anschlüssen A1 beziehungsweise A2 auf. Durch den Einsatz der beiden Stromquellen Q1 und Q2, welche sich jeweils an entgegengesetzten Enden der Wortleitung WLk befinden, ergibt sich durch das Superpositionsprinzip ein im Vergleich zu Figur 5 wesentlich gleichmäßigerer Verlauf des wirksamen Stroms Ig. Die Abweichung △I12 ist dabei im Vergleich zur Abweichung ΔI nach Figur 5 im wesentlichen halbiert. Die Zuverlässigkeit des Speichers hinsichtlich der zu speichernden Daten ist auch weitgehend gewahrt, wenn zum Beispiel infolge von Alterung ein Leckstrom einer der Speicherzellen MC1 bis MC3 zunimmt, da ein größerer Abstand zum Strom Imin vorhanden ist.

Die Kontaktierungen der Wortleitung WLk beziehungsweise der Bitleitungen BLi-1 bis BLi+1 mit den Speicherzellen MC1 bis MC3 sind in Figur 2 (entsprechend in Figur 4) jeweils nur symbolisch dargestellt. Physikalisch sind die Leitungen unmittelbar über den Speicherzellen angeordnet, da das von dem jeweiligen Strom erzeugte Magnetfeld ausschlaggebend für den jeweiligen Schreibvorgang ist. Die gezeigten Speicherzellen sind hier aus jeweils drei Schichten aufgebaut. Sie weisen eine hartmagnetische Schicht HM, eine Tunnelbarriere TB und eine weichmagnetische Schicht WM auf. Bei einem Schreibvorgang wird dabei die jeweilige weichmagnetische Schicht WM von dem erzeugten Magnetfeld in einen bestimmten Zustand versetzt. Anhand dieses Zustands ist zu einem späteren Zeitpunkt die gespeicherte Information aus der Speicherzelle auslesbar.

## Patentansprüche

1. Integrierter Speicher
- mit Speicherzellen (MC1 bis MC3) mit magnetoresistivem Speichereffekt, die jeweils mit einer gemeinsamen elektrischen Leitung (WLk) verbunden sind,
- bei dem die Leitung (WLk) eine erste Leiterbahn (LB1) und eine zweite Leiterbahn (LB2) aufweist,
- bei dem die Leitung (WLk) einen ersten Anschluß (A1) und zweiten Anschluß (A2) aufweist und zwischen den Anschlüssen (A1, A2) an Kopplungsknoten (x1 bis x3) mit den Speicherzellen (MC1 bis MC3) verbunden ist,
- bei dem der erste Anschluß (A1) der ersten Leiterbahn (LB1) mit einer Stromquelle (Q1) und der zweite Anschluß (A2) der zweiten Leiterbahn (LB2) mit einer weiteren Stromquelle (Q2) verbunden sind zum Einschreiben von Information in eine der Speicherzellen (MC1 bis MC3).

2. Integrierter Speicher nach Anspruch 1,
**dadurch gekennzeichnet, daß**
- die Speicherzellen (MC) in einem Speicherzellenfeld (1) angeordnet sind, das Spaltenleitungen (BL0 bis BLn) und Zeilenleitungen (WL0 bis WLm) aufweist, und jeweils mit einer der Spaltenleitungen (BL0 bis BLn) und einer der Zeilenleitungen (WL0 bis WLm) verbunden sind,
- die gemeinsame Leitung (WLk) eine der Zeilenleitungen (WL0 bis WLm) oder eine der Spaltenleitungen (BL0 bis BLn) bildet.

3. Integrierter Speicher nach Anspruch 2,
**dadurch gekennzeichnet, daß**
der erste Anschluß (A1) und der zweite Anschluß (A2) an gegenüberliegenden Seiten des Speicherzellenfeldes (1) angeordnet sind.

4. Integrierter Speicher nach einem der Ansprüche 2 oder 3,
**dadurch gekennzeichnet, daß**
die Stromquelle (Q1) und die weitere Stromquelle (Q2) an gegenüberliegenden Seiten des Speicherzellenfeldes (1) angeordnet sind.

5. Integrierter Speicher nach einem der vorhergehenden Ansprüche,
**dadurch gekennzeichnet, daß**
die Stromquelle (Q1) und die weitere Stromquelle (Q2) einen gleichen Schaltungsaufbau aufweisen.
